# EUROPÄISCHE PATENTANMELDUNG

(11) **EP 3 419 049 A1**
(43) Veröffentlichungstag der Anmeldung: **26.12.2018**
(21) Anmeldenummer: 17177361.7
(22) Anmeldetag: 22.06.2017
(51) Int. Cl.: H01L 21/67, H01L 21/687, C23C 16/46, H01L 23/34, C23C 16/458

(54) **BEHEIZBARER WAFERTRÄGER UND BEARBEITUNGSVERFAHREN**

(71) Anmelder: Meyer Burger (Germany) GmbH, 09337 Hohenstein-Ernstthal (DE)
(72) Erfinder: Ansorge, Erik, 09127 Chemnitz (DE); Pietzsch, Rocco, 08064 Zwickau (DE); Kehr, Mirko, Badstraße 17 Amtsberg (DE); Raschke, Sebastian, 09380 Thalheim (DE)
(74) Vertreter: Kailuweit & Uhlemann Patentanwälte Partnerschaft mbB

(57) **Zusammenfassung**

Die Erfindung betrifft einen beheizbaren Waferträger zum Heizen von Wafern im Zusammenhang mit einem Bearbeitungsverfahren wenigstens eines auf dem Waferträger aufnehmbaren Wafers mit einer gegenüber einer Rückseite des Wafers vorgesehenen Heizplatte. Es ist die Aufgabe der Erfindung, einfach aufgebaute beheizbare Waferträger vorzuschlagen, die eine Waferbearbeitung mit einer guten Temperaturhomogenität ermöglichen und die auch als ebene Waferträger für mehr als einen Wafer ausbildbar sind. Die Aufgabe der Erfindung wird mit einem beizbaren Waferträger gelöst, bei dem die Heizplatte eine große Emissivität für Wärmestrahlung hat und auf der Heizplattenrückseite wenigstens ein Heizelement angeordnet ist, wobei die Heizplatte mit dem Heizelement eine integrale Einheit bildet und wobei die große Emissivität insbesondere an wellenlängenabhängigen Emissionskoeffizienten ε = ε(λ) > 0,7 in dem Wellenlängenbereich von λ = 0,8 bis λ = 18 µm ersichtlich ist.

## Beschreibung

Die vorliegende Erfindung betrifft einen beheizbaren Waferträger, der eine Heizplatte mit einer Heizplattenvorderseite und einer Heizplattenrückseite aufweist, wobei wenigstens ein Wafer an der Heizplattenvorderseite des Waferträgers aufnehmbar und während wenigstens eines Teilschritts eines Bearbeitungsverfahrens des Wafers von der Heizplatte beheizbar ist sowie ein entsprechendes Bearbeitungsverfahren.

Der Begriff Wafer wird in dem vorliegenden Dokument für verschiedene plattenförmige Substrate gebraucht, wie sie zur Herstellung elektronischer Bauelemente verwendet werden. Für die Herstellung mikroelektronischer Bauelemente haben Wafer in der Regel eine runde Form, an der je nach Größe der Wafer eine Abflachung oder eine Einbuchtung zur Positionsmarkierung angebracht ist. Im Bereich der Fotovoltaik sind statt runder Wafer quadratische und quadratähnliche Wafer weit verbreitet. Des Weiteren gibt es großflächige quadratische oder rechteckige Substrate, beispielsweise für die Herstellung von Flachbildschirmen, die hier auch mit unter den Begriff Wafer fallen. Die Wafer durchlaufen bei der Herstellung elektronischer Bauelemente eine Reihe von Fertigungsschritten, die teilweise bei erhöhten Temperaturen ablaufen. Zu diesen Fertigungsschritten gehören Temperaturbehandlungen in einer inerten oder einer reaktiven Atmosphäre, chemische Gasphasenabscheidungen mit und ohne Plasmaunterstützung (z.B. CVD, PE-CVD, ALD, Epitaxie) und physikalische Gasphasenabscheidungen. Für eine hohe Qualität hergestellter Bauelemente sollen die Bearbeitungsschritte auf allen Wafern und auf allen Stellen der Wafer möglichst definiert ablaufen. Dafür ist oft eine genaue, homogene und schnelle Einstellung der Temperatur der Wafer erforderlich. Zur Erreichung niedriger Bauelementpreise soll die Bearbeitung zudem in möglichst kurzen Zeiten pro Wafer erfolgen.

Während der Bearbeitung eines Wafers in einer Bearbeitungskammer sind die Wafer auf einem Waferträger angeordnet, teilweise auch beim Transport der Wafer in die Bearbeitungskammer hinein und aus dieser heraus. Der Waferträger kann eine großflächige horizontale Oberfläche aufweisen, auf der der Wafer abgelegt wird. Der Wafer kann aber auch auf einem kleineren Flächenbereich, beispielsweise einem Ring oder auf kleinen Auflagestiften aufliegen. Es gibt auch Waferträger, in welche Wafer in einer vertikalen Ausrichtung geklemmt sind oder in einer zumindest nahezu vertikalen Ausrichtung hineingestellt sind. Verschiedene Waferträger sind zur Aufnahme einzelner Wafer oder mehrerer Wafer ausgebildet. Maschinen, die mehrere Wafer gleichzeitig bearbeiten, werden auch als Batch-Anlagen bezeichnet. Bei den Batchanlagen gibt es wieder verschiedene Anordnungsmöglichkeiten. In einem Typ eines Batchofens können mehr als 100 einzelne Wafer in einen als Boot bezeichneten Waferträger gelegt und dann gemeinsam in einem rohrförmigen Reaktor bearbeitet werden. Beispielsweise für Plasmabearbeitungen gibt es auch ebene, arrayförmige Waferträger, bei denen beispielsweise 5 × 5 Wafer auf einem flächigen Waferträger angeordnet sind. Solche Waferträger sind im Bereich der Fotovoltaik weit verbreitet. Des Weiteren sind Batch-Anlagen bekannt, beispielsweise aus DE 10 2008 019 023 B4, bei denen mehrere Stapel von einzelnen Wafern bzw. Mini-Batches auf einem ebenen Waferträger angeordnet sind.

Für die Temperierung auf eine Bearbeitungstemperatur von einzelnen Wafern oder flächiger Waferträger, mit mehreren darauf befindlichen Wafern, werden im Stand der Technik Flächenheizer eingesetzt, die die gesamte Fläche erwärmen. Im Falle von Widerstandsheizern sind diese Flächenheizer in der Regel thermisch sehr träge. Andere Flächenheizer sind beispielsweise aus mehreren Lampen zusammengesetzt und in DE 42 10 519 C1 beschrieben. Ein in einer Vakuumkammer angeordneter Flächenheizer mit Lampenfeldern benötigt Bauraum und eine ausreichend große Vakuumkammer. Große Volumen einer Vakuumkammer sind mit langsamen Evakuierungs- und Belüftungszeiten verbunden. Ein weiterer Nachteil bekannter Flächenheizer kann darin bestehen, dass die Fläche der Waferträger mit unzureichender Temperatur-Homogenität beheizt wird, wodurch ein der Anordnung der Lampen entsprechender inhomogener, beispielsweise linienförmiger "Temperatur-Abdruck" der Lampen entsteht. Die Temperaturinhomogenität in einem Beschichtungsverfahren kann zu einer Schichtdickeninhomogenität der abgeschiedenen Schicht oder einer anderen Prozessergebnis-Inhomogenität führen. Für technisch anspruchsvolle Prozesse, beispielsweise epitaktische Abscheidungen, kann die von einer flächigen Lampenanordnung erzeugte Temperaturhomogenität unzureichend sein. Der Aufbau der Heizung ist teilweise aufwendig und teuer und es gibt viele Fehlerquellen beispielsweise Vakuum-Lecks an Heizerdurchführungen oder Spannungsüberschläge an den vakuumseitigen Lampenzuleitungen infolge hoher Spannungen, die für große Lampenleistungen benötigt werden.

Für homogene Abscheidungen auf Mikroelektronik-Wafern werden deshalb beispielsweise Einzelwaferkammern eingesetzt, bei denen in der Abscheidekammer ein Waferträger, der auch als Suszeptor bezeichnet wird, angeordnet ist. Der Suszeptor kann einen Flächenheizer mit mehreren Heizzonen aufweisen. Solche Flächenheizer können beispielsweise mäanderförmig auf einer Fläche angeordnete Heizdrähte aufweisen, die in einer Keramik eingebettet sind. Solche keramischen Heizer sind teuer und ihre Baugröße hat praktische Grenzen. Für die Herstellung von Solarzellen in Batchanlagen sind solche Heizer ungeeignet. Des Weiteren gibt es Waferträger, bei denen eine Auflage- oder Kontaktplatte für die Wafer indirekt durch Lampen oder andere Heizelemente beheizt ist. DD 276 385 A1 beschreibt einen Waferträger mit einem flächigen Heizelement, der aus einem Stapel mehrerer Platten besteht, zwischen denen ein Wärmeübergang teilweise durch Wärmestrahlung in evakuierten, konstruktiv für eine gute Temperaturverteilung bemessenen Hohlräumen erfolgt. Solche Waferträger haben eine große Masse und entsprechend auch eine große thermische Masse. Folglich sind solche Waferträger nicht für häufige, schnelle Temperaturwechsel oder als Waferträger in Durchlaufanlagen, bei denen der Waferträger durch eine Bearbeitungskammer hindurchfährt, geeignet.

Es ist deshalb die Aufgabe der vorliegenden Erfindung, einfach aufgebaute beheizbare Waferträger vorzuschlagen, die eine Waferbearbeitung mit einer guten Temperaturhomogenität ermöglichen und die auch als ebene Waferträger für mehr als einen Wafer ausbildbar sind, es gehört auch zu der Aufgabe der Erfindung, ein Bearbeitungsverfahren wenigstens eines Wafers vorzuschlagen, bei dem durch eine gute Temperaturhomogenität eine homogene Bearbeitung möglich ist.

Die Aufgabe der Erfindung wird durch einen beizbaren Waferträger gelöst, bei dem die Heizplatte eine große Emissivität für Wärmestrahlung hat und auf einer Rückseite der Heizplatte wenigstens ein Heizelement angeordnet ist, wobei die Heizplatte (2) mit dem Heizelement (8, 8') eine integrale Einheit bildet und wobei die große Emissivität insbesondere an wellenlängenabhängigen Emissionskoeffizienten ε = ε(λ) > 0,7 in dem Wellenlängenbereich von λ = 0,8 bis A = 18 µm ersichtlich ist.

Die große Emissivität ist beispielsweise in einem Emissionsspektrum im Wellenlängenbereich von λ = 0,8 bis λ = 18 µm daran ersichtlich, dass die wellenlängenabhängigen Emissionskoeffizienten ε = ε(λ) im Wesentlichen > 0,7 sind. Im Wesentlichen bedeutet, dass bei den meisten Wellenlängen die Emissionskoeffizienten > 0,7 sind, dass es aber in im Vergleich mit dem gesamten Wellenlängenbereich kleinen Wellenlängenbereichen Ausnahmen mit kleineren Emissionskoeffizienten geben kann. Im Mittel über alle Wellenlängen im Wellenlängenbereich von λ = 0,8 bis λ = 18 µm sind Emissionskoeffizienten > 0,7, insbesondere > 0,8, teilweise > 0,9. Die Emissivität ist eine integrale Größe über alle Wellenlängen, der Begriff Emissionskoeffizient wird hier hingegen als wellenlängenabhängiger Koeffizient verwendet. Die Größen "Emissivität" und "Emissionskoeffizient" sind relative Größen mit einem Wertebereich von 0 bis 1 oder von 0 bis 100%, wobei das Bezugsobjekt mit 100% Emissivität ein idealer schwarzer Strahler ist. Die Emissivität ist eine optische Materialeigenschaft, die angibt, wie gut vorhandene Wärmeenergie abgestrahlt wird. Konkret ist hier insbesondere die in Richtung der Flächennormale der Heizplatte austretende, gerichtete Emissivität εₙ relevant. Praktisch wird die Emissivität beispielsweise als Strahlungsleistung gemessen, die von einer 1000°C warmen Probe ausgestrahlt wird. Eine Messgerätekalibrierung kann durch die Messung einer Vergleichsprobe mit bekannten Emissionskoeffizienten bei der gleichen Temperatur erfolgen. Die Heizplatte kann eine gleichmäßige Temperatur annehmen und die gleichmäßige Temperatur gleichmäßig an den Wafer abstrahlen bzw. emittieren.

Die Heizplatte des Waferträgers kann eine geringe Dicke haben. Geringe Dicke bedeutet eine kleine Dicke von typischerweise wenigen Millimetern. Die Dicke ist dabei so minimiert, dass die bestehenden mechanischen Anforderungen an den Waferträger erfüllt sind. Zu den mechanischen Anforderungen an einen horizontalen Waferträger gehört das Unterschreiten einer zulässigen Maximaldurchbiegung, die durch das Eigengewicht der Platte und die Gewichtsbelastung der Wafer oder thermische Ausdehnungen der Heizelemente verursacht werden. Ein vorteilhafter Effekt der geringen Dicke ist eine entsprechend kleine thermische Masse, die ein schnelles und effizientes Aufheizen und teilweise auch Abkühlen ermöglicht. Die absoluten Werte der Dicke und der thermischen Masse hängen von der Größe und dem Typ des Waferträgers ab. Vertikale Waferträger können dünner als horizontale Waferträger ausgebildet werden. Beispielsweise können vertikale Waferträger für vier Solarwafer mit Dicken von wenigen Millimetern, insbesondere minimal 3 Millimetern ausgebildet werden. Die thermische Masse ist eine zur Fläche proportionale Größe. Eine kleine thermische Masse kann deshalb als eine auf die Fläche normierte Größe angegeben werden. Beispielsweise hat eine 5 mm dicke Quarzplatte eine flächenbezogene thermische Masse von 11,6 kJ/(m² *K). Auch das Heizelement hat eine kleine thermische Masse.

Durch die geringe Dicke der Heizplatte und die Anordnung der Heizelemente direkt an der Rückseite der Heizplatte unter Ausbildung einer integralen Einheit hat der erfindungsgemäße beheizbare Waferträger insgesamt ein kleines Volumen und eine kleine thermische Masse. Somit sind gleichzeitig ein schnelles Aufheizen und eine sehr gute Temperaturhomogenität möglich. Das vorteilhaft geringe Volumen des beheizbaren Waferträgers ermöglicht des Weiteren kompakt bemessene Anlagenkammern, in denen schnell eine vorgegebene Evakuierung oder Gasfüllung durchgeführt werden kann. Teilweise werden die Waferträger auch außerhalb einer Bearbeitungsanlage verwendet. Durch die geringe Dicke und Masse sind die erfindungsgemäßen Waferträger gut und einfach transportierbar und von passenden Transportvorrichtungen handhabbar. Insgesamt sind somit Verfahren der Waferbearbeitung mit kurzen Verfahrensschritten, schnellen Abläufen und insgesamt großer Dynamik möglich. Durch Verwendung geeigneter Materialien ist der Waferträger trotz seiner geringen Dicke auch bei hohen Temperaturen stabil gegen plastische Verformungen.

Die Heizplatte ist eine Platte mit einer Heizplattenvorderseite und einer Heizplattenrückseite, deren Breite und Länge deutlich größer als die Dicke sind, wobei bei größeren lateralen Abmessungen regelmäßig auch die Dicke größer ist. Auf der Heizplattenvorderseite ist wenigstens ein Wafer anordenbar. Die Heizplattenrückseite ist mit einem oder mehreren Heizelementen verbunden, wobei das oder die Heizelemente Wärme an die Heizplatte abgeben können, sodass diese Wärme wiederum von der Heizplatte abgestrahlt werden kann. Bei den Heizelementen handelt es sich vorzugsweise um elektrische Widerstandsheizelemente, die sich beim Durchleiten eines elektrischen Stromes erwärmen. Der Waferträger kann für Heizraten des Wafers bis 15 K/s ausgebildet sein, wobei der Waferträger insbesondere auch eine geringe Dicke und eine kleine thermische Masse hat. Eine geringe Dicke und eine entsprechend kleine thermische Masse unterstützten eine schnelle Beheizbarkeit. In jedem Fall muss der Waferträger auch ausreichend starke Heizelemente und daraus gebildete Heizer aufweisen. Neben der maximalen Heizrate können kleinere Heizraten oder konstante Temperaturen eingestellt werden. Der Waferträger kann auch mit Abkühlraten bis 15K/s abgekühlt werden, allerdings erfordert das vor allem bei Temperaturen von wenigen 100°C eine aktive Kühlung, z.B. durch Verwendung eines Kühlgases. Ein Kühlgas und die Heizelemente können gemeinsam verwendet werden, um eine definierte Abkühlrate einzuregeln.

Die Heizplatte kann wenigstens ein Kühlelement aufweisen und mit diesem eine integrale Einheit bilden. Durch den Kontakt des Kühlelements mit der Heizplatte kann ein kleiner thermischer Widerstand realisiert werden, sodass die Wärme von dem Wafer und der Heizplatte gut abgeführt werden kann. Das Kühlelement kann ein Kanal sein, welcher sich entlang der Heizplattenrückseite erstreckt. Durch den Kanal kann ein Kühlmedium strömen, welches Wärme von der Heizplatte aufnimmt und abführt. Bei dem Kühlmedium kann es sich um ein Kühlmedium, beispielsweise Stickstoff, handeln. Zum Abkühlen auf tiefe Temperaturen, insbesondere auf Raumtemperatur oder auf eine Temperatur unter Raumtemperatur, kann auch eine geeignete Kühlflüssigkeit durch einen Kühlkanal geleitet werden. Bei einer aus Quarz bestehenden Heizplatte kann der Kühlkanal beispielsweise ein Quarzrohr sein, welches unter Verwendung von Quarzpulver auf die Heizplattenrückseite geschweißt ist. Analog kann auch eine Kühlplatte hergestellt werden, die keine Heizfunktion hat und keine Heizplatte ist. Es können auch andere Kühlelemente, beispielsweise wärmeableitende Schichten oder Heatpipes, zum Einsatz kommen.

Bei der Heizplatte mit der großen Emissivität kann es sich um eine Heizplatte aus schwarzem Quarz, Graphit, SiC und/oder Al₂O₃ handeln. Quarz bzw. Quarzglas ist ein im Wesentlichen nur aus Siliziumdioxid bestehendes Glas. Dieses Material wird in Substratbearbeitungsanlagen auch zur Herstellung von Waferträgern eingesetzt, weil es eine Reihe von vorteilhaften Eigenschaften besitzt. Zu den vorteilhaften Eigenschaften zählen eine für Gläser relativ hohe Temperaturbelastbarkeit bis ca. 1000°C, kurzzeitig sogar darüber, eine gute Toleranz gegen Temperatur-Wechselbeanspruchungen, wobei diese auch mit dem sehr kleinen thermischen Ausdehnungskoeffizienten von Quarz zusammenhängt, und eine gute chemische Beständigkeit gegenüber vielen Chemikalien. Infolge der guten chemischen Beständigkeit besitzt Quarz eine gute Prozesskompatibilität mit vielen bei Abscheideprozessen verwendeten Gas- oder Plasmazusammensetzungen und bei Reinigungen verwendeten gasförmigen oder flüssigen Chemikalien. Die gute Prozesskompatibilität wird beispielsweise an einer guten Partikelperformance, das heißt, wenigen auf bearbeiten Wafern zu findenden Partikeln, deutlich. Das Material ist insbesondere mit Halbleiterwafern kompatibel, da keine Diffusionen oder Reaktionen auftreten, die das Halbleitermaterial schädigen könnten.

Neben dem visuell transparenten Quarzglas, das gemeinhin bekannt ist, wurde in letzter Zeit auch visuell schwarzes Quarzglas entwickelt, das beispielsweise von der Firma Haraeus unter dem Namen "HBQ" hergestellt wird. Dieses Material kann auch vorteilhaft als Heizplatte in einem erfindungsgemäßen Waferträger verwendet werden, da es eine große Emissivität nahe 1 besitzt. In dem Spektralbereich von 0,8 bis 18 µm, in dem die Heizenergie hauptsächlich übertragen wird, liegen die Emissionskoeffizienten durchgehend über 0,7 und somit mehrfach über denen von transparentem Quarzglas. Die große Emissivität bewirkt sowohl eine homogene Erwärmung der Heizplatte als auch des Wafers. Der Waferträger kann dabei im Wesentlichen insgesamt aus dem schwarzen Quarz hergestellt sein. Der Waferträger kann aber auch ein im Wesentlichen 2-teiliger Gegenstand sein, wobei die Heizplatte in einem die Heizplatte umgebenden Rahmen aus Quarzglas angeordnet ist. Der Rahmen kann dabei aus transparentem oder aus opakem Quarzglas bestehen. Der Waferträger kann also aus mehreren Teilen, dem Rahmen der Heizplatte und weiteren Teilen, bestehen, wobei nur der Teil, der im Kontakt mit dem Wafer vorgesehen ist, nämlich die Heizplatte, aus dem schwarzen Quarz besteht. Ein äußerer Teil des Waferträgers, der von dem Wafer bzw. den Wafern weiter entfernt ist, und dessen Aufgabe nicht in der Ausstrahlung von Wärmestrahlung besteht, kann als ein Rahmen ausgebildet sein, in dem die Heizplatte aus dem schwarzen Quarzglas aufgenommen ist. Statt des schwarzen Quarzglases kann auch ein anderes Material hoher Emissivität verwendet werden, z.B. SiC oder Graphit. Die Heizplatte kann auch mehrschichtig aufgebaut sein, z.B. aus einem gesinterten SiC- oder einem Graphit-Kern, der mit einer CVD-SiC-Schicht oder einer anderen Schicht, z.B. aus Al₂O₃, beschichtet ist.

Das Heizelement kann als eine Beschichtung auf der Rückseite der Heizplatte aufgebracht bzw. aus einer Beschichtung hergestellt sein. Je nach dem vorgesehenen Temperaturbereich des Heizers kann es sich bei der Beschichtung beispielsweise um eine durch Siebdrucken einer Metallpaste (z.B. einer Silberpaste) und anschließendes Tempern hergestellte Metallschicht, eine gesputterte und/oder elektrolytisch aufgebrachte Platinschicht oder um eine andere leitfähige Schicht beispielsweise aus einer Eisenlegierung oder aus Kohlenstoff handeln. Das Heizelement kann auch mit einem Befestigungsmittel mit der Heizplatte verbunden sein. Das Heizelement und die das Heizelement bildende Beschichtung sind in Ausführungsbeispielen der vorliegenden Erfindung großflächige Elemente. In anderen Ausführungsbeispielen ist die Beschichtung strukturiert, insbesondere in einer Mäanderform. Durch die Strukturierung der Heizelemente kann die Wärmeleistung lokal unterschiedlich gezielt beeinflusst werden, um insgesamt eine gleichmäßige und homogene Erwärmung der Heizplatte zu bewirken. Unbeheizte Zwischenflächen zwischen einzelnen Schlingen des Mäanders oder zwischen sonstigen Heizelementstrukturen können dabei hinreichend klein bemessen sein, sodass diese keinen thermischen Abdruck auf dem Wafer erzeugen, obwohl der Wafer ohne Abstand oder in einem kleinen Abstand vor der Heizplatte angeordnet ist. Infolge der Wärmeübertragung durch Wärmestrahlung kann statt einer parallelen Ausrichtung des Wafers zur Heizplatte teilweise auch eine leicht gekippte Lage des Wafers zulässig sein, wovon insbesondere bei vertikalen Waferträgern Gebrauch gemacht wird. Durch den in den Waferträger integrierten Heizer und den zumindest nahe dazu angeordneten Wafer ergeben sich ein sehr kompakter Aufbau und eine kleine thermische Masse. Bearbeitungskammern können entsprechend klein bemessen werden. Folglich sind kurze Evakuierungszeiten, schnelle Temperatureinstellungszeiten und insgesamt kurze Bearbeitungszeiten und niedrige Kosten möglich.

Weiterhin kann der beheizbare Waferträger wenigstens einen integrierten Temperatursensor aufweisen. Der eine oder die mehreren Temperatursensoren können aus einer elektrisch leitfähigen Schicht hergestellte Widerstandsthermometer sein, die in die integrale Einheit mit der Heizplatte integriert sind, beispielsweise Platin-Messwiderstände nach dem Standard PT100. Die PT100 Sensoren können für eine präzise Temperaturmessung mit einem 4-Leitungsanschluss versehen sein. Bei der Schicht, aus der die Temperatursensoren hergestellt werden, kann es sich dabei um eine Beschichtung auf der Heizplatte handeln. Die Temperatursensoren können aber auch separat hergestellte und an der Heizplatte befestigte Bauelemente sein, beispielsweise Thermoelemente oder faseroptische Temperatursensoren.

Die Befestigung kann beispielsweise durch Klemmen, Kleben oder Bonden erfolgen. Es können auch Temperatursensoren zum Einsatz kommen, die räumlich von dem Waferträger getrennt sind, beispielsweise Pyrometer.

Der erfindungsgemäße beheizbare Waferträger kann wenigstens 2 Heizelemente und/oder wenigstens 2 Temperatursensoren aufweisen, um wenigstens 2 Heizzonen der Heizplatte separat regeln zu können. Der Waferträger kann also mehrere Temperaturzonen aufweisen, es können pro Wafer eine Temperaturzone oder pro Wafer mehrere Temperaturzonen vorgesehen sein. Durch viele Heizzonen besteht eine große Flexibilität, um bei verschiedenen Temperaturen und Temperaturprofilen homogene Temperaturen einregeln zu können. In Flächenbereichen guter Temperaturhomogenität, beispielsweise in einem zentralen Bereich der Heizplatte, können auch mehrere Wafer von einer Temperaturzone abgedeckt sein. In einer Temperaturzone können lokal unterschiedliche Heizleistungsdichten bereitgestellt werden, beispielsweise indem die Dichten von Mäanderschlaufen variiert werden. Bei der Auslegung der Heizelemente können anlagenspezifische Wärmesenken, z.B. an Befestigungsorten, durch eine größere lokal bereitgestellte Heizleistung abgeschirmt werden. Die Festlegung der Größe und der Form von Temperaturzonen hängt von der konkreten Anlage und den darin durchgeführten Verfahren ab. Zur separaten Temperaturregelung in einer Heizzone kann diese Heizzone sowohl über ein Heizelement als auch einen Temperatursensor verfügen, sodass über den Messwert des Temperatursensors die Heizleistung des Heizelements gesteuert werden kann. Bei einer Heizplatte mit nur einem einzigen Heizelement kann eine zweite Temperaturzone beispielsweise durch einen äußeren Zusatzheizer realisiert sein, der unter Verwendung eines zweiten Temperatursensors gesteuert und/oder geregelt wird. Die Begriffe Steuern und Regeln sind dem Fachmann bekannt und müssen hier nicht erklärt und differenziert werden.

Der erfindungsgemäße Waferträger kann kleinflächige Auflage-Elemente aufweisen, auf die der Wafer mit im Vergleich zu seiner gesamten Oberfläche kleinen Berührungsflächen aufgelegt wird. Beispielsweise kann zur Beladung des Waferträgers ein Wafer von einem Manipulator auf drei aus dem Waferträger herausragenden Stiften abgelegt werden, sodass der Manipulator nach der Ablage des Wafers unter dem Wafer herausgezogen werden kann. Bei einigen Anlagen erfolgt die Bearbeitung der Substrate bzw. der Wafer während diese auf solchen Auflageelementen liegen. Bei anderen Anlagen werden die beispielsweise stiftförmigen Auflagen vor der Bearbeitung eingefahren, sodass der Wafer für die Bearbeitung direkt auf dem Waferträger aufliegt. Bei vertikal verwendeten Waferträgern können die Auflageelemente beispielsweise hakenförmige Aufnahmen zum Einstellen der Wafer sein. Insbesondere für sehr dünne, bruchgefährdete Wafer können berührungslose Manipulatoren oder die Wafer nur an deren Waferrand berührende Manipulatoren verwendet werden.

Der Waferträger kann auch auf die Größe der Wafer abgestimmte Substrat-Taschen aufweisen, wobei die Wafer in die Substrat-Taschen eingelegt oder eingestellt werden und wobei Ränder der Substrat-Taschen die Position der Wafer auf dem Waferträger definieren. Durch solche Substrat-Taschen, die teilweise auch als Substrat-Nester bezeichnet werden, verfügt der Waferträger über laterale Begrenzungen der Position der Wafer, sodass bei einer Bewegung der Waferträger die Position des oder der Wafer auf dem Waferträger durch die Substrat-Taschen gesichert ist. Eine Substrattasche kann durch eine ebene Heizplatte und von der Heizplatte abstehende Lagebegrenzer gebildet sein, beispielsweise in Form von Stiften, Haken oder hinterschnittenen Randleisten. Bei vertikalen Substratträgern können schon zwei mit Köpfen versehene Stifte eine Substrattasche bzw. eine Substrataufhängung an der Heizplatte ausbilden. Bei vertikalen Waferträgern kann der Wafer in Hinterschnitte, die auch als Kerben im Substrattaschenrand bezeichnet werden können, eingestellt werden. Die Hinterschnitte können eine Länge aufweisen, die im Wesentlichen der Länge einer geraden Waferkante entspricht, oder sie können kürzer als der Wafer sein.

Die Position der Wafer während der Bearbeitung auf dem erfindungsgemäßen Waferträger ist relativ zu anderen Anlagenteilen genau definiert. Bei der Verwendung von Waferträgern aus Quarzglas verändern die Substrat-Taschen bei der Erwärmung durch die geringe thermische Ausdehnung des Quarzes kaum ihre Größe und gleichzeitig werden auch Verwölbungen vermieden, sodass die Ortsdefinition besonders gut ist. Je nach zugehöriger Anlage kann der Waferträger eine Substrat-Tasche oder mehrere Substrat-Taschen aufweisen, die arrayartig in mehreren Zeilen und/oder Spalten angeordnet sind. Beispielsweise kann ein Waferträger für Solar-Wafer als quadratische Anordnung für 2×2, 5×5, oder 10×10 Wafer ausgebildet sein. In einem anderen Beispiel ist der Waferträger für 2 rechteckige Flachbildschirmsubstrate als 1×2 Array ausgelegt.

In einer Ausgestaltung der Erfindung sind mehrere erfindungsgemäße Waferträger als ein Batch-Stapel angeordnet, wobei jeder Wafer oder jede Ebene in dem Batch-Stapel über eine eigene Heizung verfügt, die wiederum mehr als eine Heizzone und mehr als ein Heizelement aufweisen kann.

Auf der Rückseite des erfindungsgemäßen Waferträgers kann ein Wärmereflektor angeordnet sein. Der Wärmereflektor bewirkt einerseits, dass die bereitgestellte Wärmenergie effektiv zur Erwärmung des Wafers genutzt wird. Andererseits wird durch den Wärmereflektor die unerwünschte Erwärmung anderer Anlagenteile vermieden. Der Wärmereflektor kann als ein metallisches Blech, eine metallische Folie oder keramische Platte geringer Emissivität ausgebildet sein. Der Wärmereflektor kann aber auch als eine Beschichtung auf die Heizplatte und das Heizelement aufgebracht sein. Bei Beschichtung kann es sich beispielsweise um eine weiße keramische oder glasige Schicht handeln. Diese Beschichtung oder eine andere Schutzschicht kann auch einen Schutz vor korrosiven Gasen bereitstellen.

Die Aufgabe der Erfindung wird auch durch ein Bearbeitungsverfahren wenigstens eines Wafers gelöst, bei dem wenigstens während eines Teilschritts eines Bearbeitungsverfahrens der Wafer von einem erfindungsgemäßen beheizbaren Waferträger beheizt wird. Varianten erfindungsgemäßer Bearbeitungsverfahren mit entsprechend ausgebildeten Waferträgern erlauben ein Beheizen mittels der Heizplatte in mehreren Bearbeitungsschritten, beispielsweise einem Einschleuseschritt, einem Einfahrschritt in eine Beschichtungskammer und in einem Beschichtungsschritt. In anderen Varianten erfindungsgemäßer Verfahren wird die Heizplatte nur in einem Bearbeitungsschritt zum Heizen von Wafern verwendet, beispielsweise in einem Abscheideschritt. Das erfindungsgemäße Bearbeitungsverfahren liefert gleichmäßige Bearbeitungsergebnisse, es ist schnell und entsprechend kostengünstig.

Im Interesse einer knappen und verständlichen Darstellung der Erfindung wurden optionale Merkmale einfach beschrieben. Ein Fachmann kann die beschriebenen Optionen im eigenen Ermessen miteinander kombinieren, ohne dabei den Rahmen der vorliegenden Offenbarung zu verlassen. Nacheinander beschriebene Merkmale dürfen nicht als eine zwingende Merkmalskombination missverstanden werden.

Die vorliegende Erfindung soll im Folgenden anhand von Figuren weiter erläutert werden, wobei
- Figur 1: den Querschnitt eines erfindungsgemäßen beheizbaren Waferträgers,
- Figur 2a: eine perspektivische Ansicht eines erfindungsgemäßen Waferträgers,
- Figur 2b: eine Ansicht der Fläche des Waferträgers mit Wafern,
- Figur 2c: eine Ansicht der Kante des Waferträgers,
- Figur 2d: einen vergrößerten Querschnitt des Waferträgers,
- Figur 2e: eine perspektivische Ansicht des Waferträgers mit distanzierten Wafern,
- Figur 2f: eine perspektivische Ansicht des Waferträgers in horizontaler Lage,
- Figur 3a: eine perspektivische Explosionsdarstellung eines anderen erfindungsgemäßen Waferträgers,
- Figur 3b: eine perspektivische Ansicht des anderen Waferträgers,
- Figur 3c: eine Ansicht der Kante des Waferträgers und
- Figur 3d: eine Ansicht der Fläche des Waferträgers
zeigt.

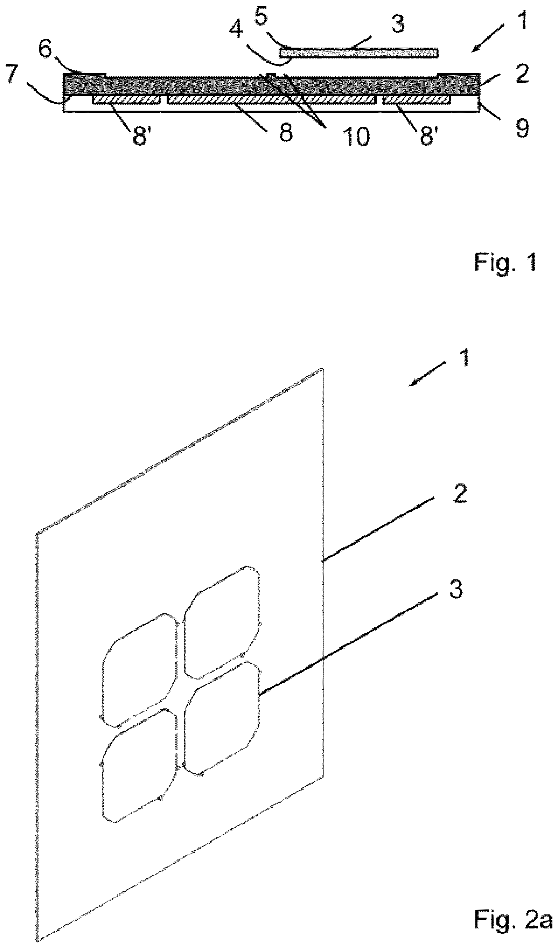

Figur 1 ist eine schematische Darstellung des Querschnitts eines erfindungsgemäßen beheizbaren Waferträgers 1, auf dem entlang des dargestellten Querschnitts die Auflage von zwei Wafern 3 nebeneinander vorgesehen ist. Der Waferträger 1 weist eine Heizplatte 2 mit einer großen Emissivität auf, die in dem dargestellten Ausführungsbeispiel aus schwarzem Quarz besteht. Die auf etwa die Bearbeitungstemperatur für den Wafer 3 erwärmte Heizplatte 2 emittiert über ihre Heizplattenvorderseite 6 Wärmestrahlung, die über die Waferrückseite 4 des Wafers 3, der bei der Bearbeitung auf der Heizplatte 2 aufliegt, in dem Wafer 3 absorbiert wird. In dem dargestellten Ausführungsbeispiel eines Querschnittsbereiches werden zwei Wafer 3 gleichzeitig bearbeitet, die jeweils in eine Substrat-Tasche 10 eingelegt sind. Bei einer Beschichtung wird dabei nur die Wafervorderseite 5 der Wafer 3 bearbeitet. In anderen, nicht dargestellten Ausführungsbeispielen werden die Wafer 3 beabstandet von der Heizplatte 2 auf Stifte aufgelegt, sodass auch eine Beschichtung der Waferrückseite 4 der Wafer 3 erfolgt. Da die Wärmeübertragung von der Heizplatte 2 auf den Wafer 3 über Wärmestrahlung erfolgt, werden die Wafer 3 trotz eines Abstandes von der Heizplatte 2 geheizt.

In dem dargestellten Ausführungsbeispiel sind auf der Heizplattenrückseite 7 der Heizplatte 2 Heizelemente 8, 8' angeordnet, die hier konkret durch Strukturierung einer metallischen Beschichtung hergestellt worden sind und einen Heizer auf der Heizplatte 2 ausbilden. Auf der sich aus der Darstellungsebene heraus erstreckenden ebenen Heizerfläche sind die Heizelemente 8, 8' mäanderförmig strukturiert, wobei die Mäander-Schlaufen so gelegt sind, dass die Heizplatte 2 homogen erwärmt wird. Für die homogene Erwärmung sind hier schematisch 2 Heizzonen dargestellt, wobei das zentral angeordnete Heizelement 8 eine erste Heizzone ausbildet und die äußeren Heizelemente 8' eine zweite Heizzone ausbilden, über welche ein größerer relativer Wärmeverlust am Rand des Waferträgers 1 kompensierbar ist.

Auf der Heizplattenrückseite 7 und auf den Heizelementen 8, 8' ist in dem dargestellten Ausführungsbeispiel eine Wärmereflexionsschicht 9 abgeschieden, die vorliegend aus einem weißen Quarzmaterial besteht. Zwischen den Heizelementen 8, 8' und der Heizplatte 2 sowie zwischen den Heizelementen 8, 8' und der Wärmereflexionsschicht 9 sind jeweils als Diffusionsbarriere und/oder Haftschicht dienende, nicht dargestellte Zwischenschichten abgeschieden. Diese Zwischenschichten bestehen beispielsweise aus Siliziumnitrid oder Aluminiumoxid. Die Heizelemente 8, 8' sind mit einem elektrischen Kontaktfeld verbunden, an welches Kontaktfedern angelegt werden, sodass elektrischer Strom durch die Heizelemente 8 und 8' geleitet werden kann. Des Weiteren sind in der Heizplatte 2 nicht dargestellte Temperatursensoren vorhanden, die ebenfalls über das nicht dargestellte Kontaktfeld elektrisch angeschlossen werden. In einem anderen nicht dargestellten Ausführungsbeispiel ist auf dem Waferträger 1 ein Leistungselektronikbaustein montiert, der die einzelnen Heizzonen ansteuert und Temperatursensoren aus den einzelnen Heizzonen ausliest und der mit wenigen elektrischen Leistungs- und Datenanschlüssen auskommt. In einem nicht dargestellten Ausführungsbeispiel sind die Leistungs- und Datenanschlüsse drahtlos realisiert.

Figur 2a zeigt perspektivisch ein Ausführungsbeispiel eines erfindungsgemäßen beheizbaren Waferträgers 1 für die vertikale Aufnahme von vier Wafern 3 in einer perspektivischen Ansicht. Die in Figur 1 dargestellten Heizelemente 8, 8' sowie die Anschlussleiste befinden sich auf der nicht sichtbaren Rückseite 7 des Waferträgers 1, welcher hier neben seiner mechanischen Funktion auch die Funktion der Heizplatte 2 hat. Dabei bilden die Heizplatte 2 und die Heizelemente 8, 8' eine integrale Einheit.

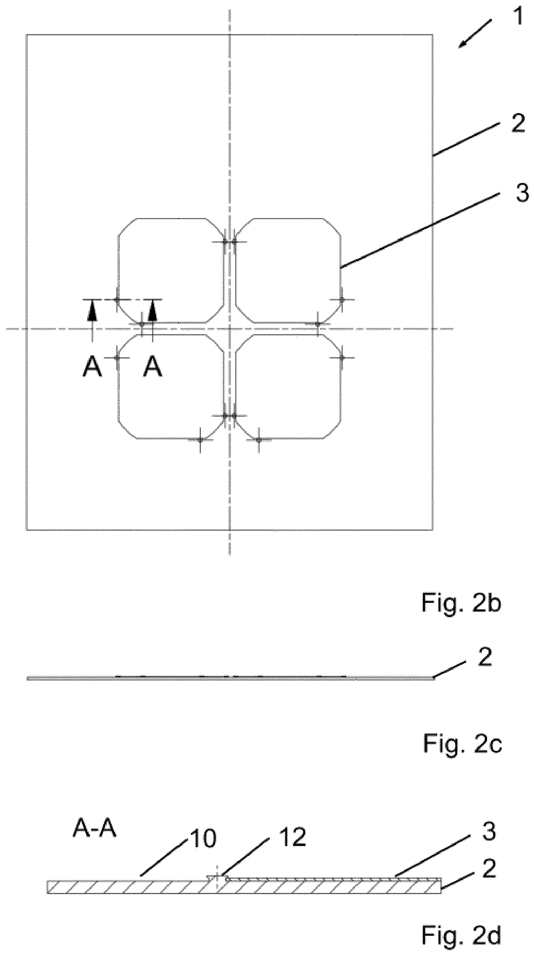

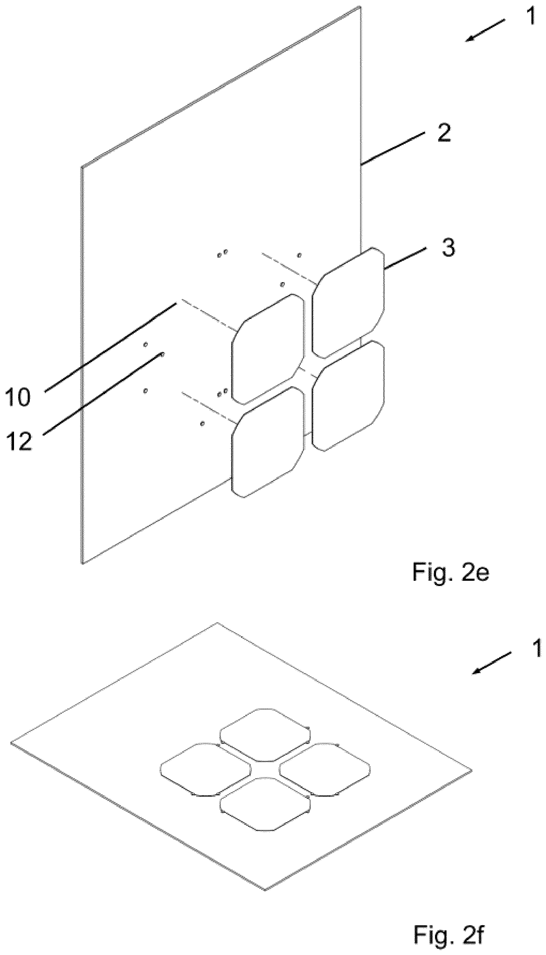

Das Ausführungsbeispiel dieses Waferträgers mit eingestellten Wafern ist des Weitern in Figur 2b in einer Ansicht der Fläche, in Figur 2c in einer Ansicht auf die Kante des Waferträgers, in Figur 2d in einem vergrößerten Querschnitt des Waferträgers entlang der in Fig. 2b eingezeichneten Schnittlinie A-A, in Figur 2e in einer perspektivische Ansicht des Waferträgers mit explosionsartig distanzierten Wafern, sowie in Figur 2f in einer perspektivischen Ansicht des Waferträgers in horizontaler Lage gezeigt.

In diesem Ausführungsbeispiel ist der Waferträger 1 ein vertikaler Waferträger 1, in den die Wafer 3 in vertikaler Orientierung in hakenförmige Aufnahmen 12 eingestellt werden. Die hakenförmigen Aufnahmen 12 sind hier endseitig ähnlich wie Köpfe von Nägeln verbreiterte Stifte, von denen jeweils drei eine Substrattasche 10 bilden, in die der Wafer 3 von oben eingestellt wird. Die hakenförmigen Aufnahmen 12 sind am besten in Fig. 2d zu erkennen. Bei der vertikalen Anordnung führt das Gewicht der Wafer 3 zu keiner Durchbiegung des Waferträgers 1. Deshalb kann der vertikale Waferträger 1 noch dünner als ein horizontaler Waferträger 1 ausgebildet werden. In dem konkreten Ausführungsbeispiel hat der Waferträger 1 eine Dicke von 5 Millimetern. Entsprechend der geringen Dicke hat diese Quarzplatte auch eine im Vergleich mit herkömmlichen Heizplatten kleine flächenbezogene thermische Masse von nur 11,6 kJ/(m² *K).

Mit dieser Dicke von 5 mm kann der Waferträger nicht nur in seiner konzeptionsgemäßen vertikalen Orientierung verwendet werden, sondern es ist auch die in Fig. 2f dargestellte weitgehend horizontale Verwendung beispielsweise bei einem Zwischenlagern zwischen Bearbeitungsschritten der Wafer 3 möglich.

Der dargestellte vertikale Waferträger 1 weist auf seiner Rückseite nicht dargestellte stromdurchfließbare Widerstandsheizelemente sowie PT100 Widerstandsthermometer auf, mit denen die Wafer homogen mit Heizraten von bis zu 15 K/s beheizbar sind. Die Widerstandsheizelemente sind mäanderförmig ausgebildet, wobei randseitige Wärmesenken durch größere Mäanderdichten kompensiert werden. Mäanderabschnitte können als Temperatursensoren genutzt werden, indem Spannungsabgriffe an Mäanderabschnitten angebracht sind. Die Temperaturhomogenität über alle 4 Wafer, beträgt bei dem dargestellten Ausführungsbeispiel 700 °C ± 5°C (min. / max.).

Der Waferträger 1 kann prinzipiell ebenso schnell abgekühlt wie aufgeheizt werden, ohne den Waferträger zu schädigen. Während die schnelle Aufheizung aktiv mit den Heizelementen realisiert werden kann, ist für eine schnelle Abkühlung vor allem bei niedrigen Temperaturen eine geeignete Kühlmaßnahme, beispielsweise eine Umspülung mit einem kühlenden Gas erforderlich. Bei hohen Temperaturen sind große Abkühlraten einfacher realisierbar, da mehr Wärme durch Wärmestrahlung abführbar ist. Wenn eine definierte Abkühlrate von bis zu 15 K/s gefordert ist, können die Kühlmaßnahme und die Heizelemente gleichzeitig betrieben werden, um die Abkühlrate auf eine Soll-Abkühlrate zu regeln. Natürlich können auch kleinere Temperaturänderungsraten als 15 K/s oder konstante Temperaturen eingestellt werden, beispielsweise während eines Abscheideschrittes in einem Abscheideverfahren.

An seiner oben gezeichneten Kante ist der dargestellte Waferträger 1 an einer nicht dargestellten Kammerverschlussplatte befestigt, durch welche auch Anschlussleitungen der Heizelemente 8, 8' und der Widerstandsthermometer durchgeführt sind. Außerhalb der Kammerverschlussplatte sind die Anschlussleitungen flexibel, sodass die Heizelemente 8, 8' während einer Bewegung des Waferträgers 1 durch die Anlage betrieben werden können, sodass z.B. unter Verwendung der Heizelemente 8, 8' das Aufheizen der Wafer 3 schon in der Einschleuskammer begonnen, in wenigstens einer Abscheidekammer eine Bearbeitungstemperatur eingeregelt und auch nach der Abscheidung ein vorgegebener Temperaturverlauf realisiert werden kann.

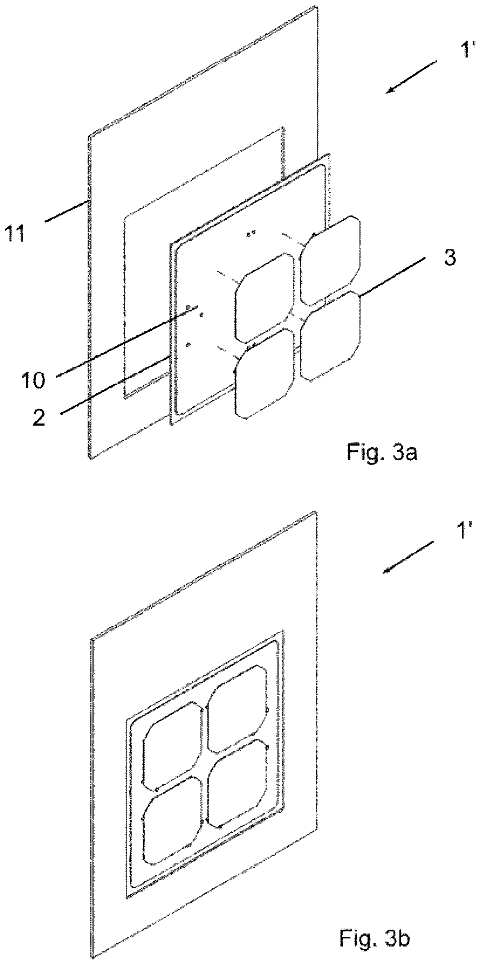

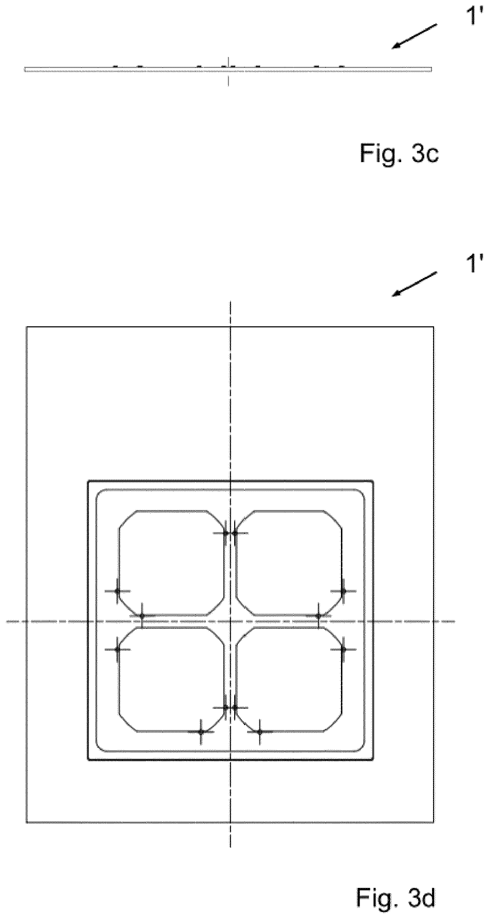

Die Figur 3a bis 3d zeigen einen anderen erfindungsgemäßen Waferträger 1', der zweiteilig aus einer Heizplatte 2' und einem Rahmen 11 zusammengesetzt ist. Die Heizplatte 2' ist hier eine quadratische Heizplatte 2' an der vier Substrat-Taschen 10 ausgebildet sind. In diesem Ausführungsbeispiel können die nicht dargestellten Heizelemente 8, 8' auf der Heizplattenrückseite 7 über Kontakte mit Zuleitungen verbunden werden, die auf dem Rahmen 11 des Waferträgers verlegt sind.

### Bezugszeichen

- 1,1': Waferträger
- 2,2': Heizplatte
- 3: Wafer
- 4: Waferrückseite
- 5: Wafervorderseite
- 6: Heizplattenvorderseite
- 7: Heizplattenrückseite
- 8,8': Heizelement
- 9: Wärmereflektor
- 10: Substrat-Tasche
- 11: Rahmen (des Waferträgers)
- 12: hakenförmige Aufnahme

## Patentansprüche

1. Beheizbarer Waferträger (1, 1'), der eine Heizplatte (2) mit einer Heizplattenvorderseite (6) und einer Heizplattenrückseite (7) aufweist, wobei wenigstens ein Wafer (3) an der Heizplattenvorderseite (6) des Waferträgers (1, 1') aufnehmbar und während wenigstens eines Teilschritts eines Bearbeitungsverfahrens des Wafers (3) von der Heizplatte (2) beheizbar ist, **dadurch gekennzeichnet, dass** die Heizplatte (2) eine große Emissivität für Wärmestrahlung hat und auf der Heizplattenrückseite (7) wenigstens ein Heizelement (8, 8') angeordnet ist, wobei die Heizplatte (2) mit dem Heizelement (8, 8') eine integrale Einheit bildet und wobei die große Emissivität insbesondere an wellenlängenabhängigen Emissionskoeffizienten ε = ε(λ) > 0,7 in dem Wellenlängenbereich von λ = 0,8 bis λ = 18 µm ersichtlich ist.

2. Beheizbarer Waferträger (1, 1') nach Anspruch 1, **dadurch gekennzeichnet, dass** die Heizplatte (2) für eine Waferbearbeitung im Temperaturbereich von 200 °C bis 1100°C, insbesondere für den Temperaturbereich von 600°C bis 800°C an der Wafervorderseite (5) des Wafers ausgebildet ist

3. Beheizbarer Waferträger (1, 1`) nach Anspruch 2, **dadurch gekennzeichnet, dass** der Waferträger (1, 1') für eine Aufheizung des Wafers (3) mit Heizraten zwischen 0 und 15 K/s ausgebildet ist, wobei der Waferträger (1, 1') insbesondere auch eine geringe Dicke und eine kleine thermische Masse hat.

4. Beheizbarer Waferträger (1, 1') nach Anspruch 1, **dadurch gekennzeichnet, dass** die Heizplatte (2) wenigstens ein Kühlelement aufweist und mit diesem eine integrale Einheit bildet.

5. Beheizbarer Waferträger (1, 1`) nach Anspruch 4, **dadurch gekennzeichnet, dass** das Kühlelement ein Kanal ist, welcher sich entlang der Heizplattenrückseite (7) erstreckt.

6. Beheizbarer Waferträger (1, 1') nach Anspruch 1, **dadurch gekennzeichnet, dass** die Heizplatte (2) aus einem schwarzen Quarz, Graphit, SiC und/oder Al₂O₃ besteht.

7. Beheizbarer Waferträger (1, 1') nach Anspruch 6, **dadurch gekennzeichnet, dass** der Waferträger (1, 1') im Wesentlichen 2-teilig aufgebaut ist, wobei die Heizplatte (2) in einem die Heizplatte (2) umgebenden Rahmen (11) aus Quarzglas angeordnet ist.

8. Beheizbarer Waferträger (1, 1') nach Anspruch 1, **dadurch gekennzeichnet, dass** das wenigstens eine Heizelement (8, 8') als eine Beschichtung auf der Heizplattenrückseite (7) aufgebracht ist.

9. Beheizbarer Waferträger (1, 1') nach Anspruch 8, **dadurch gekennzeichnet, dass** die Beschichtung strukturiert ist, insbesondere in einer Mäanderform.

10. Beheizbarer Waferträger (1, 1') nach Anspruch 1, **dadurch gekennzeichnet, dass** der beheizbare Waferträger (1, 1') wenigstens einen integrierten Temperatursensor aufweist.

11. Beheizbarer Waferträger (1, 1') nach Anspruch 1, **dadurch gekennzeichnet, dass** der beheizbare Waferträger (1, 1') wenigstens zwei Heizelemente (8, 8') und/oder wenigstens zwei Temperatursensoren aufweist, um wenigstens zwei Heizzonen der Heizplatte (2) separat regeln zu können.

12. Beheizbarer Waferträger (1, 1') nach Anspruch 1, **dadurch gekennzeichnet, dass** der Waferträger (1, 1') kleinflächige Auflage-Elemente aufweist, auf die der Wafer (2) mit im Vergleich zu seiner gesamten Oberfläche kleinen Berührungsflächen auflegbar ist.

13. Beheizbarer Waferträger (1, 1') nach Anspruch 1, **dadurch gekennzeichnet, dass** eine Heizplattenvorderseite (6) auf die Größe der Wafer (3) abgestimmte Substrat-Taschen (10) aufweist, wobei die Wafer (3) in die Substrat-Taschen (3) einlegbar oder einstellbar sind und Ränder der Substrat-Taschen (10) oder hakenförmige Aufnahmen (12) die Position der Wafer (3) auf dem Waferträger (10) definieren.

14. Beheizbarer Waferträger (1, 1') nach Anspruch 13, **dadurch gekennzeichnet, dass** die Heizplatte (2) mehrere arrayartig in mehreren Zeilen und/oder mehreren Spalten angeordnete Substrat-Taschen (10) aufweist.

15. Beheizbarer Waferträger (1, 1') nach Anspruch 1, **dadurch gekennzeichnet, dass** auf der Rückseite des Waferträgers (1, 1') ein Wärmereflektor (9) angeordnet ist.

16. Beheizbarer Waferträger (1, 1') nach Anspruch 8 und 15, **dadurch gekennzeichnet, dass** der Wärmereflektor (9) als eine Beschichtung auf der Heizplatte (2) und dem Heizelement (8, 8') ausgebildet ist.

17. Bearbeitungsverfahren wenigstens eines Wafers (3), **dadurch gekennzeichnet, dass** wenigstens während eines Teilschritts eines Bearbeitungsverfahrens der Wafer (3) von einem beheizbaren Waferträger (1, 1') nach wenigstens einem der Ansprüche 1-16 beheizt wird.
